# EUROPEAN PATENT SPECIFICATION

(11) **EP 2 075 352 B1**
(45) Date of publication and mention of the grant of the patent: **24.07.2013**
(21) Application number: 07807030.7
(22) Date of filing: 11.09.2007
(51) Int. Cl.: C23C 14/08, C23C 14/30, H01J 9/02

(54) **VACUUM PROCESSING SYSTEM**
VAKUUMVERARBEITUNGSSYSTEM
SYSTÈME DE TRAITEMENT SOUS VIDE

(30) Priority: 22.09.2006 JP 2006257404
(43) Date of publication of application: 01.07.2009
(73) Proprietor: Ulvac, Inc., Chigasaki-shi, Kanagawa 253-8543 (JP)
(72) Inventor: IIJIMA, Eiichi, Chigasaki-shi, Kanagawa 253-8543 (JP); MASUDA, Yukio, Chigasaki-shi, Kanagawa 253-8543 (JP); ISO, Yoshiki, Chigasaki-shi, Kanagawa 253-8543 (JP); HAKOMORI, Muneto, Chigasaki-shi, Kanagawa 253-8543 (JP)
(74) Representative: Albutt, Anthony John
(86) International application number: PCT/JP2007/067621
(87) International publication number: WO 2008/035587

(56) References cited:
- JP-A- 06 346 231
- JP-A- 10 152 769
- JP-A- 63 259 074
- JP-A- 2004 010 943
- JP-A- 2005 344 137

## Description

### Technical Field

The present invention relates to a vacuum processing apparatus for irradiating a vapor deposition material with an electron beam of a pierce-type electron gun and forming a deposited layer on a processed substrate.

### Background Art

For example, a film made of magnesium oxide (MgO) or the like which is formed on a glass substrate for a plasma display panel (PDP) as a protective layer is formed through vapor deposition. To form the vapor-deposited layer made of MgO, various methods have been developed.

As an example of the conventional methods, there is an ion-plating method in which plasma is guided onto a vapor deposition material by magnetic means to form a deposited layer on a substrate disposed above the vapor deposition material. To form a large-area, uniform, and thin layer having a low internal stress, the following has been devised. That is, an arc-discharge plasma flow is transformed into a sheet shape by applying a magnetic field, and the sheet-shaped plasma is guided onto the vapor deposition material by a magnetic field of a permanent magnet (sheeted magnet) that is elongate in a width direction of the sheet-shaped plasma, to evaporate the vapor deposition material and thus form a deposited layer on a glass substrate disposed above the vapor deposition material (see, Patent Document 1).

Further, there has been proposed a method for improving the ion-plating method, in which a distribution of sheet-shaped plasma is allowed to be finely adjusted so as not to cause the vapor deposition material in a crucible to unevenly evaporate. A plurality of permanent magnets that provide a distribution of a magnetic flux density are arranged in a line in a width direction of a glass substrate below the crucible so that the plurality of permanent magnets can move backwards and forwards with respect to a transfer direction of the glass substrate and move up and down with respect to the crucible (see, Patent Document 2). As a result, the distribution of the sheet-shaped plasma becomes uniform. Therefore, plasma beams converge into the crucible without twisting and the vapor deposition material is stably evaporated, with the result that a uniform layer quality can be obtained on the glass substrate.

Further, to homogenize luminance characteristics in an entire surface of a substrate, focusing attention on percentages of crystal/amorphous of magnesium oxide deposited on a deposition surface, electrons in a plasma atmosphere are caused to enter the deposition surface of the substrate by a magnet or a coil, to form a uniform dielectric layer on the entire substrate having a large area (see, Patent Document 3). In the ion-plating method, a plasma-flow generation apparatus is constituted of a plurality of plasma guns, a plurality of convergence coils, and a plurality of sheeted magnets in many cases. Here, magnetic field lines are caused to enter the deposition surface of the glass substrate in various directions, and mutual interferences occur in a plurality of plasma flows. As a result, the distribution is caused in the deposited layer quality of magnesium oxide deposited on the deposition surface of the substrate. Therefore, a light emitting portion (high-luminance portion) and a low-luminance portion are observed on a surface of a PDP. It is found that the light emitting portion is crystallized to be a (111)-oriented layer of MgO and the low-luminance portion is amorphous. To prevent this and homogenize the luminance characteristics over the entire surface of the glass substrate, electrons in the plasma atmosphere are caused to positively enter the entire surface of the deposition surface of the substrate, to form a homogenous dielectric layer on the entire large-area substrate.

Further, in recent years, there has been a demand for more homogenous deposition to deal with trends of increase in size of a flat panel and commercial production. In view of this, a deposition apparatus that uses an electron beam has come into use, because electrons are more easily controlled electrically and magnetically and more suitable for increasing the quality of the deposition than plasma.

For example, an in-line vacuum vapor deposition apparatus including a plurality of pierce-type electron guns has been developed. This apparatus basically has a structure in which two chambers of a loading/unloading chamber and a vapor deposition chamber or three chambers of a loading chamber, a vapor deposition chamber, and an unloading chamber are connected via a gate valve.

The outline is as follows. That is, as a heating source for continuously depositing MgO as a protective layer for the PDP, a pierce-type electron gun is mainly used. An electron beam approximately horizontally emitted from the pierce-type electron gun that is fixed to a side wall of the vapor deposition chamber is deflected by a deflection coil and focused on an evaporation point of MgO in a hearth as an evaporation source, to thereby generate an MgO vapor flow and form an evaporated MgO layer on a glass substrate mounted on a carrier that passes and moves thereabove.

There are features that the vapor deposition chamber is prevented from being exposed to the atmosphere, and an atmosphere in the vapor deposition chamber can be stably maintained because a pretreatment such as degassing and heating treatments can be performed with respect to the glass substrate or a jig attached to the glass substrate in the loading/unloading chamber or the loading chamber.

Further, a multipoint vapor deposition method has been put to practical use. In the multipoint deposition method, ingenuity has been exercised on heating of the vapor deposition material for increasing efficiency of the in-line vacuum vapor deposition apparatus including the pierce-type electron gun. A plurality of pierce-type electron guns are fixed in a row with respect to a transfer direction of the glass substrate. A beam shape of each electron beam emitted from the pierce-type electron guns is set to have a ratio of a major axis to a minor axis of 1.5 or less by using a magnet or a coil. Further, it is possible to jump to multi points in a backward and forward direction and in a rightward and leftward direction, which realizes efficient evaporation of a raw material (Patent Document 4). By setting the ratio of the major axis to the minor axis in the shape of the electron beam to 1.5 or less, the shape becomes approximately quadrate, and thus the vapor deposition material is efficiently evaporated. Further, the electron beam is jumped from an evaporation point focused thereon to another in a backward and forward direction and in a rightward and leftward direction, which can prevent an evaporation surface of an evaporation material from locally changing. As a result, it becomes possible to form a vapor-deposited layer on a surface of the substrate at a preferable deposition speed.
Patent Document 1: Japanese Patent No. 278299 (page 2, Fig. 1)
Patent Document 2: Japanese Patent Application Laid-open No. HEI 9-170074 (page 3, Fig. 2, Fig. 3)
Patent Document 3: Japanese Patent Application Laid-open No. 2003-306768 (page 4, Fig. 1)
Patent Document 4: Japanese Patent Application Laid-open No. 2004-010943 (page 3, Fig. 1)

### Disclosure of the Invention

### Problems to be solved by the Invention

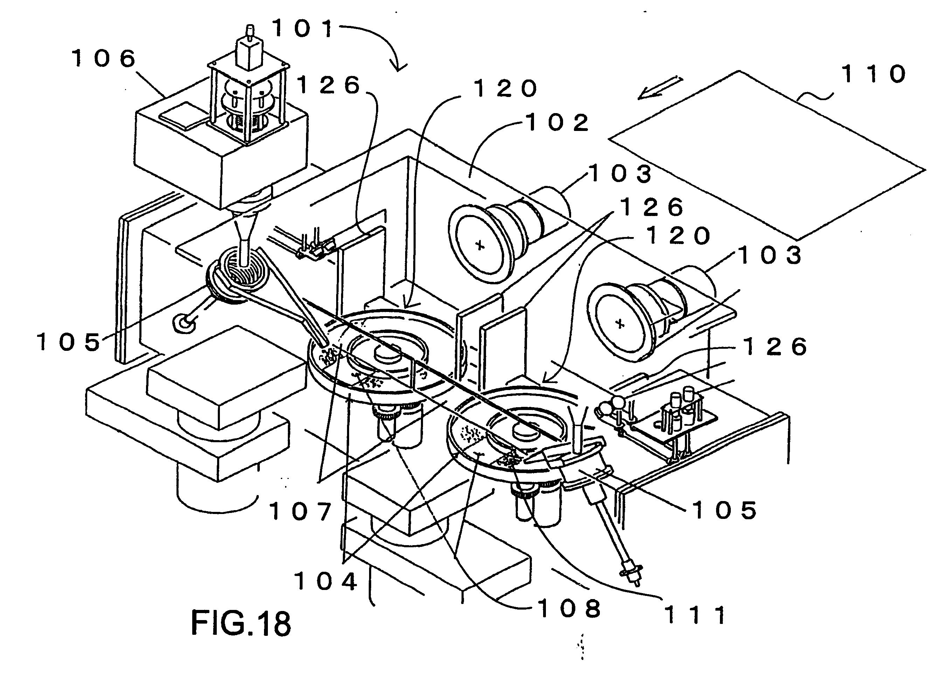

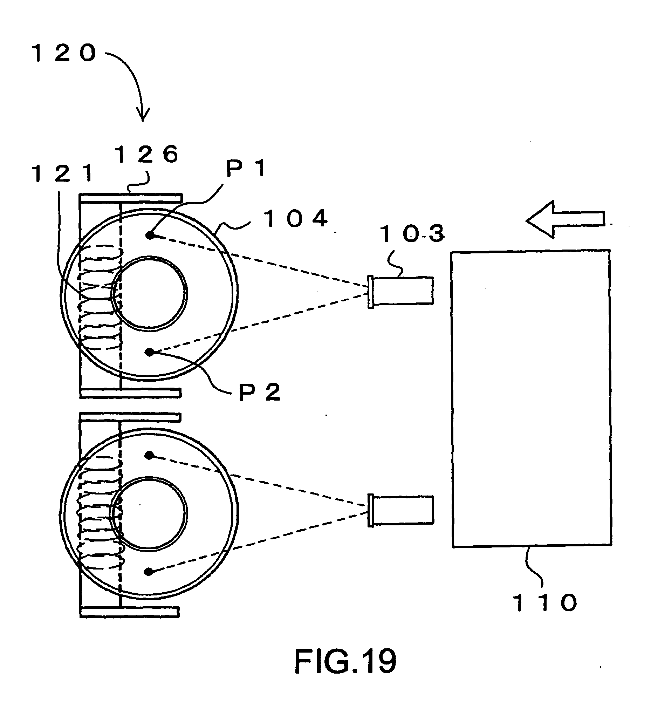

Fig. 18 is a schematic diagram showing an in-line vacuum vapor deposition apparatus 101 including a pierce-type electron gun 103 using a conventional electron-beam deflection apparatus 120. In Fig. 18, two pierce-type electron guns 103 are fixed on a wall surface of a backside viewed from a transfer direction of a glass substrate 110 in a vapor deposition chamber 102. An electron beam is approximately horizontally emitted from each of the pierce-type electron guns 103 in the transfer direction of the glass substrate 110.
In the conventional vacuum vapor deposition apparatus 101, in order to guide the electron beam from the pierce-type electron gun 103 fixed nearly horizontally to MgO 111 as the vapor deposition material and irradiate it, a magnet apparatus 120 is provided in a vacuum chamber 102, and a magnetic field generated by causing a current to flow into a deflection coil 121 (see, Fig. 19). This requires a pole piece 126 of the electron-beam deflection apparatus 120 to be provided in the vicinity of each of evaporation points P1 and P2.

Fig. 19 is a plan view schematically showing the conventional electron-beam deflection apparatus 120 shown in Fig. 18. Fig. 19 shows a positional relationship among the transfer direction of the glass substrate 110 in the vapor deposition chamber 102 of the in-line vacuum vapor deposition apparatus 101 that is used in the conventional method of forming a vapor-deposited layer, the pierce-type electron gun 103 that emits the electron beam, the ring hearth 104 on which MgO 111 is mounted, and the pole piece 126 of the conventional electron-beam deflection apparatus 120.
The two evaporation points P1 and P2 (two points for each hearth) are disposed in a direction perpendicular to the transfer direction of the glass substrate 110 (width direction of the glass substrate). The electron beam emitted from each of the pierce-type electron guns is caused to jump rightwards and leftwards and focus on the evaporation points P1 and P2. In this way, by increasing the number of evaporation points P, MgO 111 can be efficiently evaporated. The film formation was able to be carried out at approximately twice the speed as compared to the conventional vacuum vapor deposition apparatus.

However, to deal with demands for a further increase in size of the screen and a further cost reduction of the PDP, it is required to improve the vapor deposition speed, tact time, and time for continuous operation along with a further increase in size of the glass substrate.
The size of the glass substrate has been increased fourfold to eightfold since the conventional vacuum vapor deposition apparatus 101 has been developed (the number of 42-inch panels changes from 1 or 2 to 8 or more). The vapor deposition speed has increased tenfold (a dynamic rate changes from 1200 Å·m/min to 12000 Å·m/min). The tact time has improved sixfold (changes from 9 minutes to 1.5 minutes). The time for continuous operation has increased threefold or more (changes from 100 hours to 336 hours or more).

Along with the improvements of the vapor deposition speed, tact time, and time for continuous operation in response to the size increase of the glass substrate 110, the MgO film adhered to the pole piece 126 (hereinafter, referred to as accretion) grows. As a result, a vapor flow reaching the glass substrate 110 is hindered, and even the ring hearth 104 is interfered, which raises a problem of causing the surface of MgO 111 in a groove portion 104a to be rough, for example. In addition, there is a problem in that the accretion that has grown causes a rotation of the ring hearth 104 to be instable and thus causes the vapor deposition speed to be instable. It should be noted that the pole piece 126 may be provided with a shielding plate for a pole piece (not shown) for ease of cleaning in some cases, but the accretion grows on the shielding plate for a pole piece itself, which causes the similar problem.

As a countermeasure against the growth of the accretion on the pole piece 126, the pole piece 126 is distanced from the evaporation points P. However, the countermeasure cannot deal with further increases of vapor deposition speed and time for continuous operation in the future. This is because it is necessary to secure as many evaporation points P as possible in a limited space in the vapor deposition chamber 102 to increase efficiency further, but there is no mechanical, extra space for distancing the evaporation points P sufficiently.

Further, a magnetic field interference occurs between adjacent pole pieces 126. When the magnetic field interference is large therebetween, a thickness distribution of the layer becomes uneven at the time of deposition. Therefore, it is necessary to separate the adjacent pole pieces 126 by a certain distance or more, but there is a limitation on a limited space in the vapor deposition chamber 102. On the other hand, to obtain a constant thickness distribution of the layer for the vapor deposition of MgO 111 onto the glass substrate 110, an interval between the evaporation points P must not be excessively distanced. Accordingly, it is extremely difficult to take into consideration both the mechanical interference and magnetic interference in the limited space in the vapor deposition chamber 102. As a result, a sufficient deflecting magnetic field becomes difficult to be obtained and a beam incident angle to MgO becomes lower, which raises a problem of degrading the evaporation efficiency.

Further, because the sufficient deflecting magnetic field is difficult to be obtained and therefore the beam incident angle to MgO becomes lower, a thermion constituting an electron beam with which MgO is irradiated becomes a reflection electron which collides with moisture and oxygen in the vapor deposition chamber to generate a secondary electron, which causes a problem of hindering the formation of MgO layer on the surface of the substrate. Accordingly, the conventional vacuum vapor deposition apparatus 101 requires a secondary electron absorption plate 107.

Further, a local hollow of the vapor deposition material that results from unevenness of MgO evaporation due to the roughness of the surface of the vapor deposition material 111 or due to instability of the rotation of the ring hearth 104 causes further instability of the evaporation of the vapor deposition material 111. For this reason, the surface of the vapor deposition material is required to be constantly smoothed out by a scraper 108.

Further, a pipe for cooling water and the like is required to be provided in order to cool the pole piece 126 heated by adhesion of the accretion due to the provision in the vapor deposition chamber, and the deflection coil 121 for causing a large amount of current to flow to generate a magnetic field. As a result, there arises a problem in that the number of shielding plates (not shown) is increased, the configuration is complicated, and a surface area thereof is increased. Further, workability at the time of cleaning of the vapor deposition chamber becomes worse.

### Means for solving the Problems

The present invention has been made in view of the above-mentioned problems, which can be solved by a vacuum processing apparatus for irradiating a vapor deposition material contained in an evaporation source in a vacuum chamber with an electron beam of a pierce-type electron gun and forming a vapor-deposited layer on a processed substrate opposed to the evaporation source, the vacuum processing apparatus being **characterized in that** a magnet apparatus for forming a magnetic field that is approximately perpendicular to an incident direction of the electron beam and approximately parallel to an electron-beam irradiation surface of the evaporation source is provided outside the vacuum chamber on a back side of the electron-beam irradiation surface, to deflect and guide the electron beam to an evaporation point of the evaporation source.

### Effect of the Invention

In the vacuum processing apparatus, the magnet apparatus for deflecting and guiding the electron beam to the evaporation point is provided outside the vacuum chamber (evaporation chamber), thereby eliminating the pole piece. As a result, the conventional case where the accretion to the pole piece causes a rate limitation on the continuous production time is completely solved. In other words, the problem of degrading the thickness distribution of a deposited layer due to the vapor-flow interruption caused by the growth of the accretion is solved. In addition, the conventional problem that the accretion that has grown causes the rotation of the ring hearth as the evaporation source to be instable to make the vapor deposition speed instable is solved. Further, the problem that the accretion that has grown causes the surface of the vapor deposition material contained in a concave portion to be rough to make the vapor deposition rate instable is solved, which eliminate smoothing by the scraper.

Further, in the vacuum processing apparatus, the magnetic field that is approximately perpendicular to the incident direction of the electron beam and approximately parallel to the electron-beam irradiation surface of the evaporation source can be formed by the magnet apparatus provided outside the vacuum chamber (vapor deposition chamber), with the result that the electron beams are organized, and thus the unevenness for each of the pierce-type electron guns can be deduced. Also eliminated is the problem that a thermion constituting an electron beam with which MgO is irradiated becomes a reflection electron which collides with moisture and oxygen in the vapor deposition chamber to generate a secondary electron, which hinders the deposition of MgO or the like on the surface of the substrate. As a result, the secondary-electron absorption plate that is required in the conventional apparatus becomes unnecessary.

Further, the magnet apparatus is provided outside the vapor deposition apparatus and is structured by the permanent magnet, with the result that the fine adjustment of the setting position can be made and the evaporation point P can be optimized to be fitted to the substrate size. In addition, as compared to the conventional apparatus, the optimal magnetic field can be easily formed in the limited space, so the incident angle of the electron beam to MgO as the vapor deposition material can be optimized, and the multipoint vapor deposition method can be more stably carried out by the jumping of the electron beam. As a result, the vapor deposition speed with respect to the input power is increased. This is effective for optimizing a process condition for obtaining the thickness distribution of the deposited MgO layer or (111)-oriented layer. There is an advantage that the MgO layer functions as an anti-sputtering protective layer on an inner wall of a PDP cell, and the (111)-oriented layer operates to reduce an electric discharge start/sustaining voltage, because the (111)-oriented layer has a secondary-electron emission coefficient higher than that of another material.

Further, in the vacuum processing apparatus, the magnet apparatus for deflecting and guiding the electron beam is provided outside the vapor deposition chamber, thereby reducing the number of the shielding plates as compared to the conventional shielding plates, and eliminating the equipment including the cooling pipe of the deflection coil or the secondary-electron absorption plate. As a result, the vapor deposition chamber is simplified, and thus the time for cleaning the vapor deposition chamber can be reduced.

### Brief Description of Drawings

[Fig. 1] An explanatory diagram showing a positional relationship between a pierce-type electron gun and a transfer direction of a glass substrate in a vapor deposition chamber of an in-line vacuum deposition chamber of an embodiment mode of the present invention (explanatory diagram viewed from a main body side surface in the vapor deposition chamber).
[Fig. 2] A plan view showing a positional relationship among a pierce-type electron gun 3, a ring hearth 4, and permanent magnets 26a, 26b attached to a yoke 24 in the in-line vapor deposition apparatus of Fig. 1.
[Fig. 3] A partial cross-sectional view showing a positional relationship between the ring hearth 4 and the permanent magnets in the in-line vacuum vapor deposition apparatus according to the embodiment mode of the present invention. A state where a magnetic flux B passes through a wall surface of a bottom portion of a vacuum chamber and reaches a surface of the ring hearth 4 to form a parallel magnetic field section is shown.

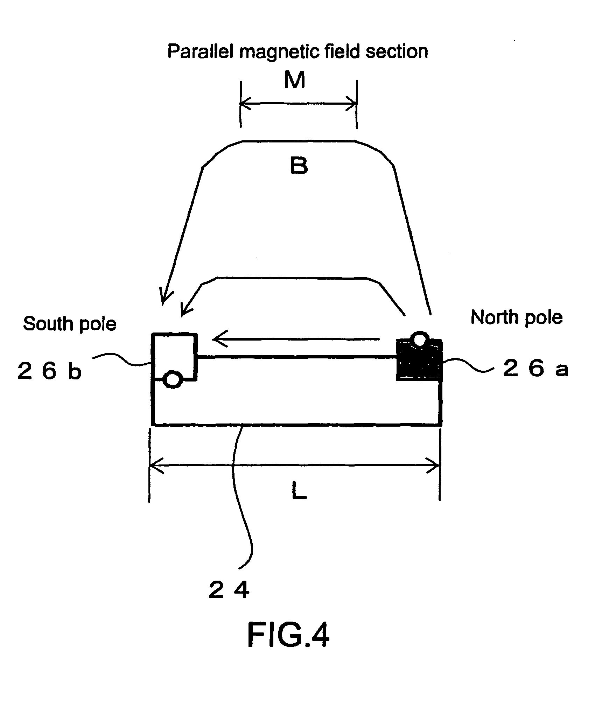

[Fig. 4] An explanatory diagram of a parallel magnetic field generated by the permanent magnets of an apparatus used in the in-line vacuum vapor deposition apparatus of the embodiment mode of the present invention. The permanent magnets 26a, 26b are bonded to both ends of the yoke 24 in a pair. In bonding, the permanent magnet 26a is bonded with its north pole directed upward and the permanent magnet 26b is bonded with its north pole directed downward so that the permanent magnet 26a and permanent magnet 26b form a magnetic circuit. Therefore, the permanent magnet 26a and the permanent magnet 26b are used as a north pole and a south pole, respectively. A magnetic flux B is generated in a space between the permanent magnet 26a as the north pole and the permanent magnet 26b as the south pole.
[Fig. 5] An explanatory diagram of Embodiment 2 of the in-line vacuum vapor deposition apparatus of the embodiment mode of the present invention. This shows an example where three ring hearths are used.
[Fig. 6] A plan view of Embodiment 2 of the in-line vacuum vapor deposition apparatus of the embodiment mode of the present invention. This shows an example where three ring hearths are used. One pierce-type electron gun 3 corresponds to one evaporation point P.
[Fig. 7] A plan view of Embodiment 3 of the in-line vacuum vapor deposition apparatus of the embodiment mode of the present invention. This shows an example of an X-jump-type multipoint vacuum vapor deposition apparatus.
[Fig. 8] A plan view of Embodiment 4 of the in-line vacuum vapor deposition apparatus of the embodiment mode of the present invention. This shows an example of an Y-jump-type multipoint vacuum vapor deposition apparatus.
[Fig. 9] A partial cross-sectional view explaining an attachment condition of a magnet apparatus 20 of the embodiment mode of the present invention. In the magnet apparatus 20, the yoke 24 to which a magnet is attached can be subjected to an angle adjustment and a position adjustment in a backward and forward direction and in a rightward and leftward direction.
[Fig. 10] A front view of the magnet apparatus 20 of the embodiment mode of the present invention.
[Fig. 11] A plan view of the magnet apparatus 20 of the embodiment mode of the present invention.
[Fig. 12] A partial cross-sectional view explaining an attachment condition of a magnet apparatus 40 of Modified Embodiment 1 of the present invention. The magnet apparatus can be subjected to a position adjustment in a backward and forward direction and in a rightward and leftward direction.
[Fig. 13] A front view of the magnet apparatus 40 of Modified Embodiment 1 of the present invention.
[Fig. 14] A plan view of the magnet apparatus 40 of Modified Embodiment 1 of the present invention.
[Fig. 15] A partial cross-sectional view explaining an attachment condition of a magnet apparatus 60 of Modified Embodiment 2 of the present invention. The magnet apparatus is formed to be as thin as possible.
[Fig. 16] A front view of the magnet apparatus 60 of Modified Embodiment 2 of the present invention.
[Fig. 17] A plan view of the magnet apparatus 60 of Modified Embodiment 2 of the present invention.
[Fig. 18] An explanatory diagram showing a positional relationship between a pierce-type electron gun and a transfer direction of a glass substrate in a vapor deposition chamber of a conventional in-line vacuum deposition chamber (explanatory diagram viewed from a main body side surface in the vapor deposition chamber). In a vapor deposition chamber 102, an electron-beam deflection apparatus 120 is provided. A secondary-electron absorption plate is also provided, and therefore the space in the vapor deposition chamber is small.
[Fig. 19] A plan view showing a positional relationship between the pierce-type electron gun and a ring hearth in the in-line vacuum deposition chamber of Fig. 18.

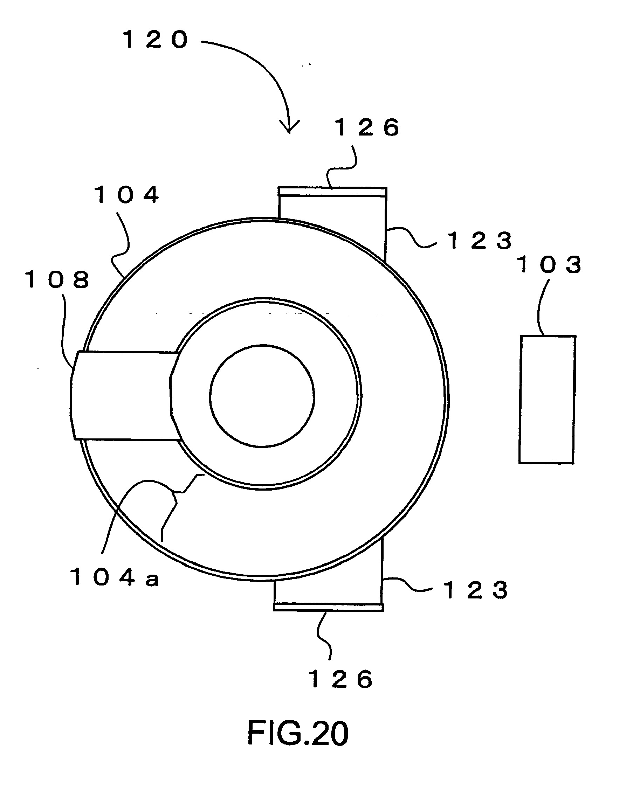

[Fig. 20] A plan view of a conventional electron-beam deflection apparatus. Conventionally, a scraper 108 is provided.

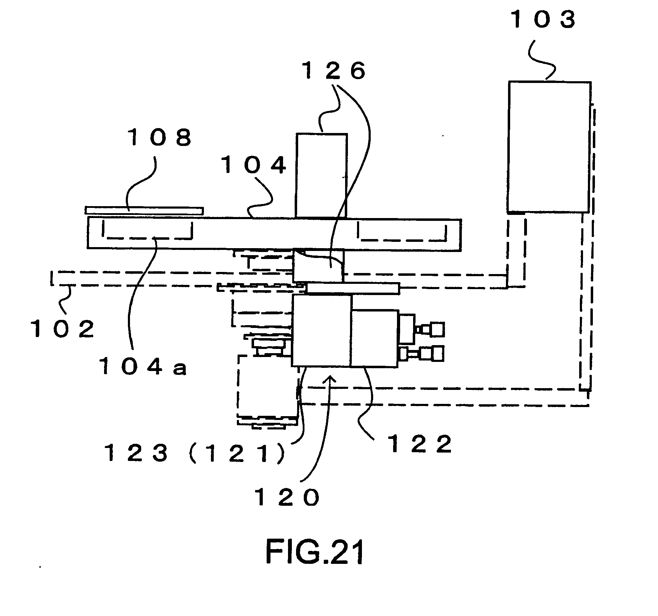

[Fig. 21] A side view of the conventional electron-beam deflection apparatus. Conventionally, cooling pipe equipment is required. A water conversion adapter for deflection coil 122 is a part thereof.

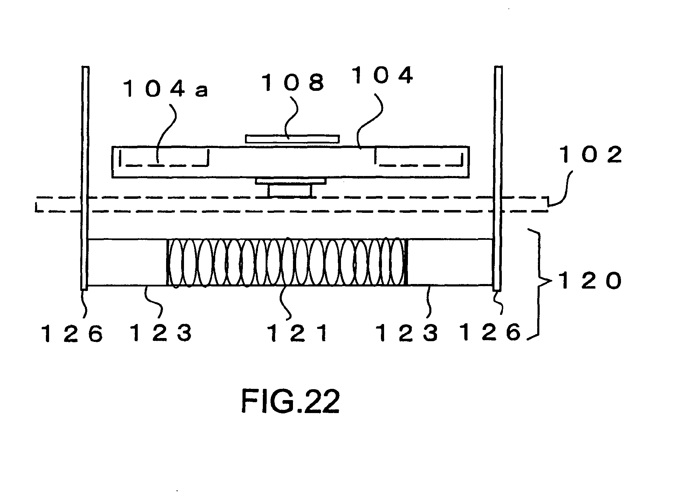

[Fig. 22] A front view of the conventional electron-beam deflection apparatus.
[Fig. 23] An example of a shape of an electron beam by the magnet apparatus of this embodiment mode. This shows a state in which a square range of the evaporation point P is irradiated on the ring hearth.
[Fig. 24] An example of a shape of an electron beam by the magnet apparatus of this embodiment mode. This is an enlarged diagram at the evaporation point P. The irradiation is conducted in a quadrate shape without distortion.
[Fig. 25] An example of a shape of an electron beam by a conventional electron-beam deflection apparatus for comparison. The shape of the evaporation point P is distorted.
[Figs. 26] Schematic diagrams of the in-line vacuum vapor deposition apparatus. Fig. 26A shows a case of two chambers, and Fig. 26B shows a case of three chambers.

### Description of Symbols

- 1: vacuum processing apparatus
- 2: vapor deposition chamber
- 3: pierce-type electron gun
- 4: ring hearth
- 4a: groove portion
- 5: feeder
- 6: material supply apparatus
- 10: glass substrate
- 20: magnet apparatus
- 21: mounting bracket
- 22: mounting plate (1)
- 23: mounting plate (2)
- 24: yoke
- 24a: yoke center
- 25: protractor
- 26a: permanent magnet (north pole)
- 26b: permanent magnet (south pole)
- 27: slot
- 28: slot
- 29: rotation center shaft
- 40: magnet apparatus
- 41: mounting bracket
- 42: mounting plate (1)
- 43: mounting plate (2)
- 44: yoke
- 46a: permanent magnet (north pole)
- 46b: permanent magnet (south pole)
- 47: slot
- 48: slot
- 60: magnet apparatus
- 61: mounting bracket
- 62: mounting plate (1)
- 63: mounting plate (2)
- 64: yoke
- 66a: permanent magnet (north pole)
- 66b: permanent magnet (south pole)
- 67: slot
- 68: slot
- 69: rotation center shaft
- 81, 82: in-line vacuum vapor deposition apparatus
- 83: loading/unloading chamber
- 84: loading chamber
- 85: unloading chamber
- 91: exhaust port
- 94-96: door
- 97-98: gate valve
- 101: vacuum processing apparatus
- 102: vapor deposition chamber
- 103: pierce-type electron gun
- 104: ring hearth
- 104a: groove portion
- 105: feeder
- 106: material supply apparatus
- 107: secondary-electron absorption plate
- 108: scraper
- 110: glass substrate
- 111: vapor deposition material
- 120: electron-beam deflection apparatus
- 121: deflection coil
- 122: water conversion adapter for deflection coil (one of water cooling pipe equipment)
- 123: auxiliary yoke
- 126: pole piece
- B: magnetic flux
- L: dimension of yoke
- M: parallel magnetic field section
- N: deflecting coil
- P, P1, P2: evaporation point

### Best Mode for carrying out the Invention

Hereinafter, a specific embodiment mode to which the present invention is applied will be described in detail with reference to the drawings.

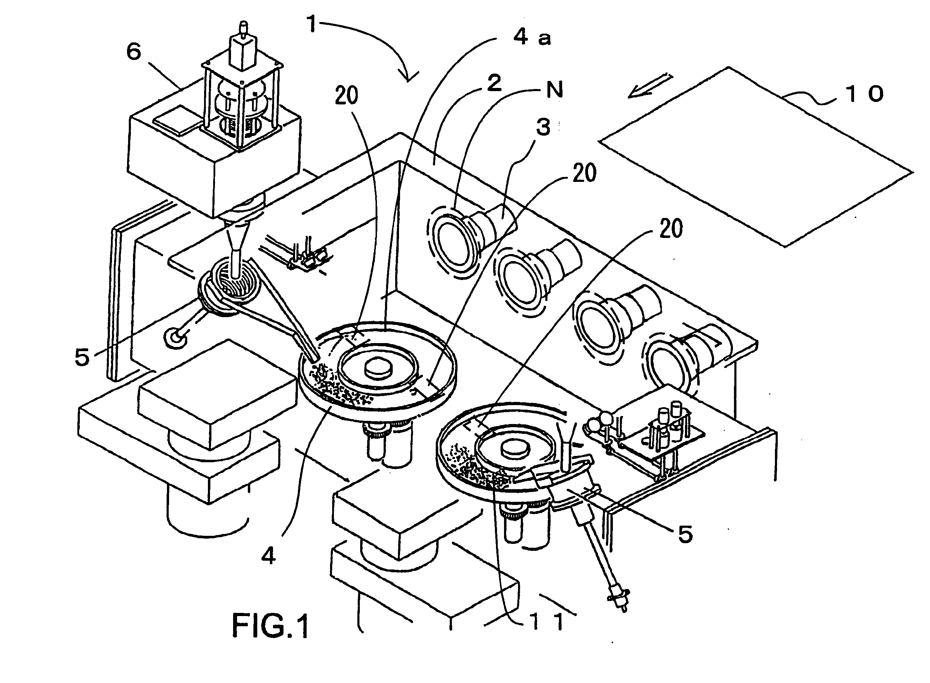

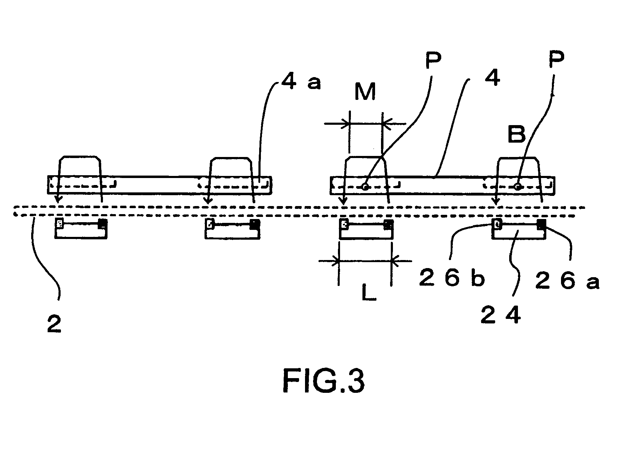

The embodiment mode of the present invention is shown in Figs. 1 to 4. First, with reference to Figs. 1 to 4, a structure of an apparatus will be described. Fig. 1 is a diagram showing a positional relationship among a transfer direction of a glass substrate 10, a pierce-type electron gun 3 for generating an electron beam, and a ring hearth 4 that contains a vapor deposition material 11 in a vacuum chamber (vapor deposition chamber) 2 of an embodiment of an in-line vacuum vapor deposition apparatus 1 used for forming a vapor-deposited layer according to the embodiment mode of the present invention. A magnet apparatus 20 for deflecting an electron beam that is used in the present invention is provided on a back side of the ring hearth 4 outside the vapor deposition chamber 2 (in atmosphere) for each of evaporation points (see, Fig. 3).

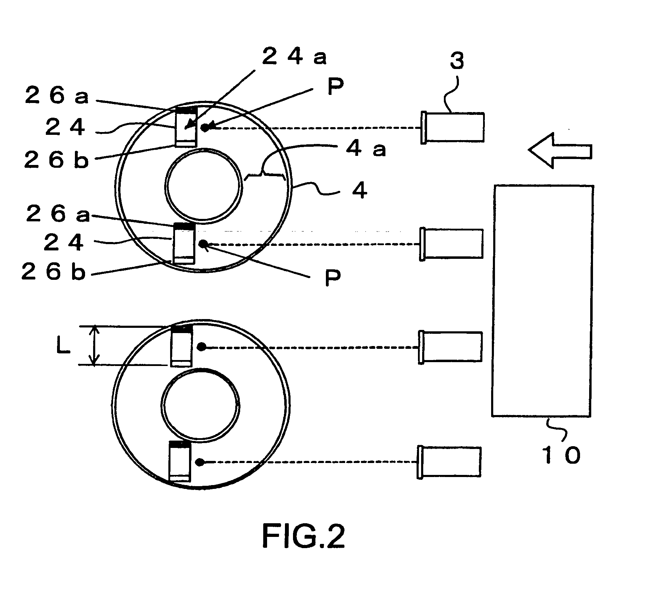

Fig. 2 is an explanatory diagram showing an arrangement of permanent magnets 26a, 26a of the magnet apparatus 20 according to the embodiment mode of the present invention. An intensity of the permanent magnets 26a, 26b is determined such that a magnetic field of about 10 to 30 gausses can be obtained on a surface of MgO serving as the vapor deposition material 11 in a groove portion 4a of the ring hearth 4. Further, a dimension L (see, Fig. 4) of a yoke 24 is determined so as to structure a magnetic circuit in which an approximately parallel magnetic field is obtained in a sweep range of the beam. Further, positions of the evaporation points and the magnet apparatus 20 are optimized so that the incident angle of the electron beam becomes high. In this embodiment, an adjustment is made such that 30 gausses or more above a center 24a of the yoke 24 as a midpoint of the permanent magnets 26a, 26b on the surface of the ring hearth 4 is set, and a magnetic flux B of 10 gausses or more is obtained at the evaporation points P on the surface of the ring hearth 4.

Fig. 3 is a partial cross-sectional view of the vapor deposition chamber 2, which shows a positional relationship between the ring hearth 4 and the permanent magnets 26a, 26b. The ring hearth 4 is provided inside the vapor deposition chamber (on a vacuum side). Meanwhile, the permanent magnets 26a, 26b are provided outside the vapor deposition chamber 2 (on an atmosphere side). For a material of a portion on which the permanent magnets 26a, 26b below a bottom surface of the vapor deposition chamber 2, a material having permeability is used.

Fig. 4 is an enlarged view showing a part of the permanent magnets of the magnet apparatus 20 according to the embodiment mode of the present invention. The permanent magnets 26a, 26b are bonded to the both ends of the yoke 24. A north pole on one end thereof is connected to a south pole on the other end via the yoke 24, to generate the magnetic flux B above and thus form a magnetic circuit. The parallel magnetic field section of the magnetic flux B is used for controlling the electron beam. In addition, the dimension L of the yoke 24 is determined so that a dimension M of the parallel magnetic field section covers the sweep range of the electron beam.

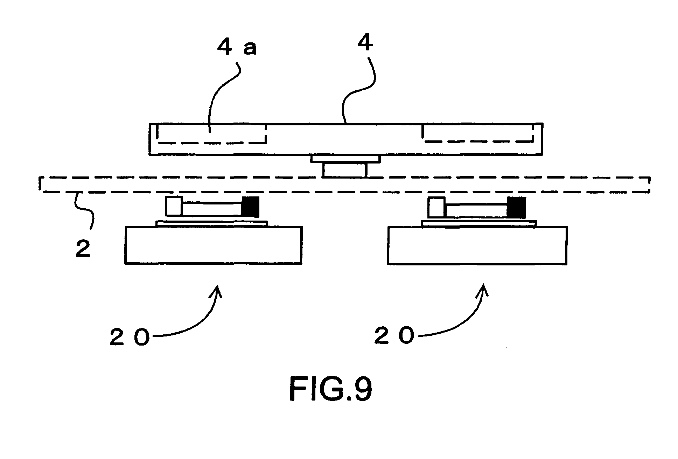

Further, with reference to Figs. 9 to 11, Embodiment 1 of the magnet apparatus 20 for deflecting the electron beam used in the present invention will be described in detail.

Fig. 9 is an explanatory diagram showing a positional relationship between the ring hearth 4 and the magnet apparatus 20 according to the embodiment mode of the present invention. Below the ring hearth 4 on the bottom surface of the vapor deposition chamber 2, the magnet apparatus 20 is disposed.

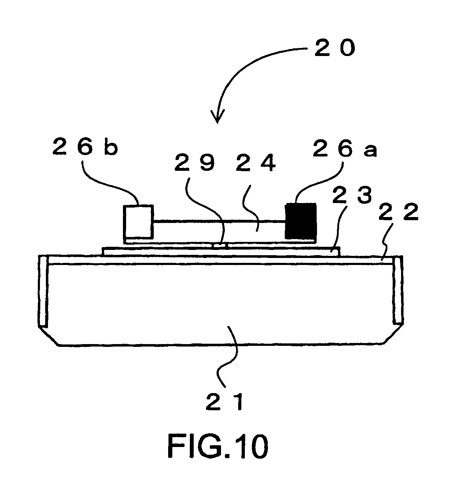

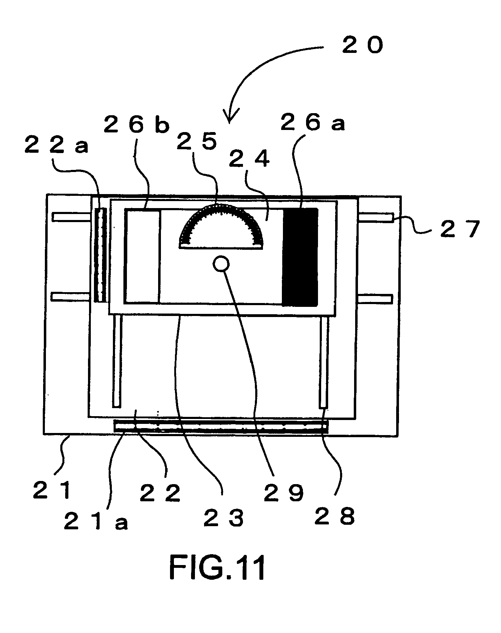

Fig. 10 is a front view of the magnet apparatus 20. Fig. 11 is a plan view of the magnet apparatus 20. A mounting plate 22 is mounted on a mounting bracket 21 adjustably in a rightward and leftward direction with a slot 27. Next, a mounting plate 23 is mounted on the mounting plate 22 so that a position of the mounting plate 23 can be adjusted backwards and forwards with a slot 28. Further, on the mounting plate 23, the yoke 24 to which the permanent magnets 26a, 26b are bonded is mounted through a rotation center shaft 29. Further, a protractor 25 for a fine adjustment, a scale 22a for a position adjustment, and a scale 21a for a position adjustment are additionally processed with respect to the mounting plate 23, the mounting plate 22, and the mounting bracket 21, respectively. With this structure, the angle and the position of the yoke 24 to which the permanent magnets 26 are bonded can be accurately adjusted. It should be noted that screws and the like used for mounting are not shown because they are positioned on the back sides of the mounting plates.

Next, a function of the magnet apparatus 20 will be described. In Fig. 2, when an electron beam (dotted line) is horizontally emitted from each pierce-type electron gun 3, the electron beam travel straight above the ring hearth 4. The magnet apparatus 20 is disposed below the ring hearth 4, and above the ring hearth 4, the magnetic flux B is generated in a direction perpendicular to the electron beam. The electron beam is deflected downward by the magnetic flux B and focused on the evaporation point P. The magnet apparatus 20 has been subjected to the accurate angle and position adjustment, and thus can scan the evaporation point P without distortion properly based on control of a deflecting coil (not shown) of the pierce-type electron gun 3. As a result, the vapor deposition material 11 on the ring hearth 4 can be efficiently evaporated, and thus various effects described above can be obtained.

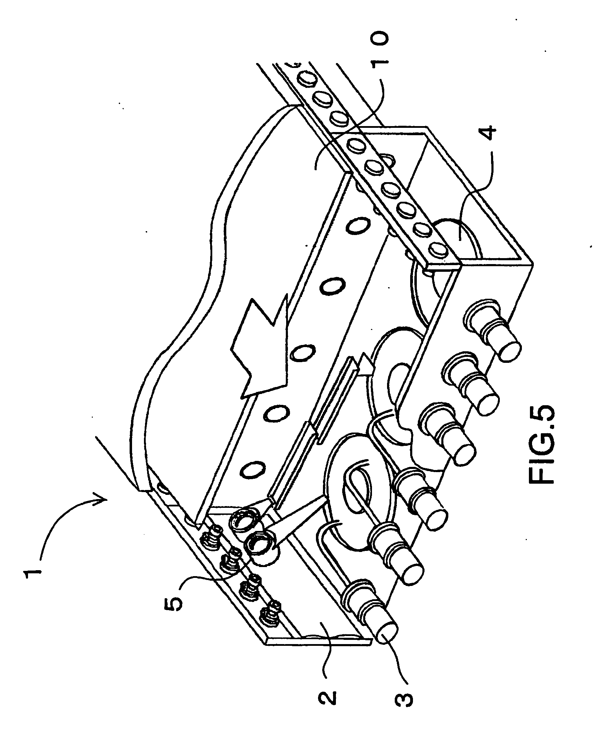

The embodiments of the present invention are described above. The present invention can be used for a vacuum processing apparatus having another structure. Figs. 5 to 8 each show an example of a vacuum vapor deposition apparatus having another structure.

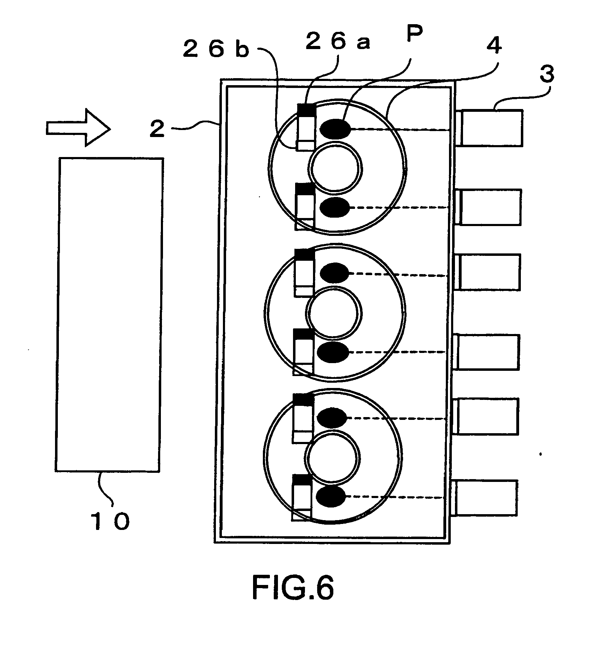

Figs. 5 to 6 shows an embodiment in a case where the number of ring hearths 4 is three. Fig. 5 is a schematic diagram showing the vapor deposition chamber 2 of the in-line vacuum vapor deposition apparatus 1 in the case where the number of ring hearths is three. Fig. 6 is a plan view showing a positional relationship among the transfer direction of the glass substrate 10, the pierce-type electron gun 3, and the magnet apparatus 20 in the vapor deposition chamber 2 of the apparatus shown in Fig. 5. In this embodiment, the pierce-type electron guns 3 are arranged and fixed in a row sideways in front of the glass substrate 10 in the transfer direction thereof. One pierce-type electron gun 3 corresponds to one evaporation point P. According to the embodiment mode of the present invention, six magnet apparatuses 20 can be arranged at sufficient intervals. Therefore, mechanical and magnetic mutual interferences do not occur, which enables preferable deposition.

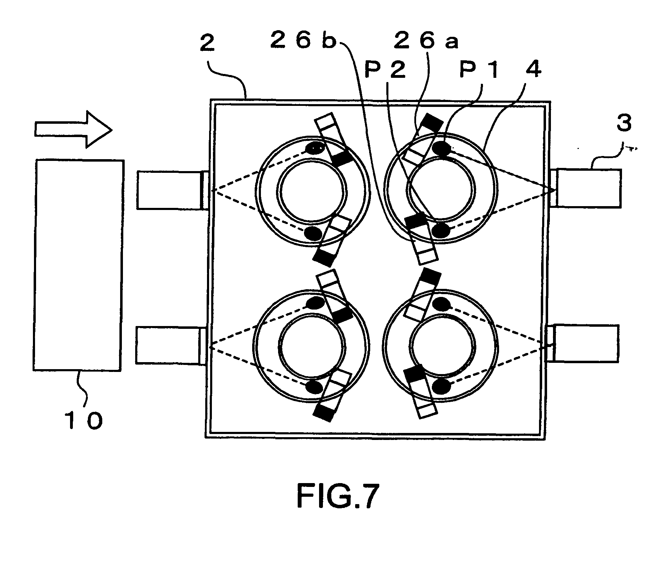

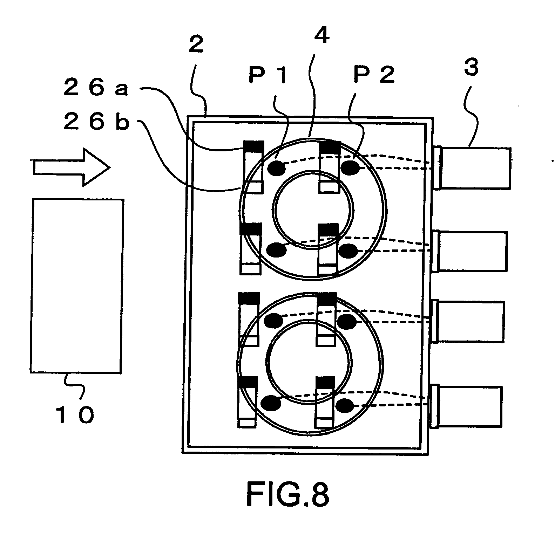

Further, the present invention can be applied to a multipoint-type vacuum vapor deposition apparatus. Fig. 7 is a diagram showing an example in which the present invention is applied to a vacuum vapor deposition apparatus of an X-jump-type multipoint vapor deposition. A beam emitted can be jumped rightwards and leftwards by a deflecting coil (not shown) contained in each of the pierce-type electron guns. Fig. 8 is a diagram showing an example in which the present invention is applied to a vacuum vapor deposition apparatus of a Y-jump-type multipoint vapor deposition. A beam emitted can be jumped backwards and forwards by the deflecting coil (not shown) contained in each of the pierce-type electron guns. The beam can also be jumped backwards/forwards and rightwards/leftwards, although not shown. Of course, the deflecting coil is not limited to one contained in the pierce-type electron gun, and may be separately provided in an outside N (see, Fig. 1) of the electron gun, for example. As described above, it is possible to dispose the magnet apparatuses 20 at sufficient intervals even in a case where one pierce-type electron gun 3 corresponds to a plurality of evaporation points P. Therefore, the mechanical and magnetic mutual interferences are prevented, which enables the preferable deposition.

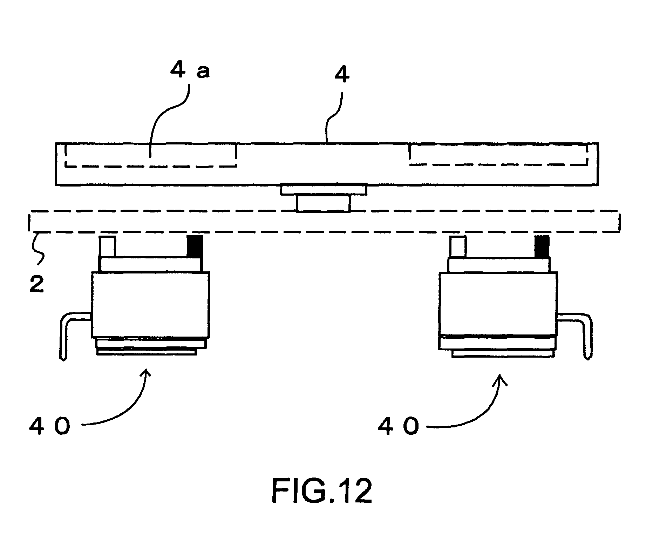

Further, the magnet apparatus 20 used in the present invention may be transformed in accordance with the vacuum vapor deposition apparatus used. Figs. 12 to 14 each show Modified Embodiment 1 of a magnet apparatus. This magnet apparatus 40 is an example in a case where an angle adjustment of a yoke 44 to which permanent magnets 46a, 46b are bonded is unnecessary. This is because, in a case where one pierce-type electron gun 3 is fixed to one evaporation point P to perform irradiation, an adjustment has to be made only in the backward and forward direction and in the rightward and leftward direction. In Fig. 12, the magnet apparatus 40 is disposed below the ring hearth 4.

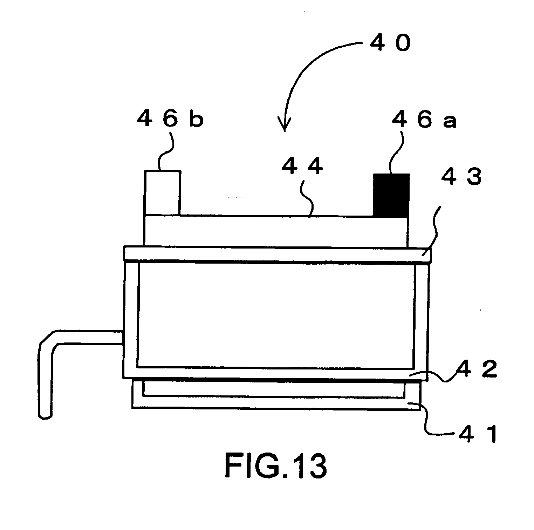

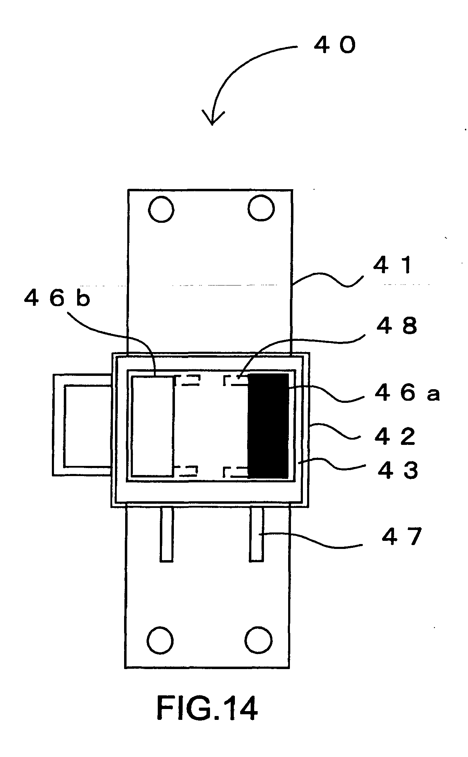

Fig. 13 is a front view of the magnet apparatus 40. Fig. 14 is a plan view of the magnet apparatus 40. A mounting plate 42 is mounted on a mounting bracket 41 so that the position of the mounting plate 42 can be adjusted backwards and forwards with a slot 47. A mounting plate 43 is attached to the mounting plate 42 so that a position of the mounting plate 43 can be adjusted rightwards and leftwards with a slot 48. Further, on the mounting plate 43, the yoke 44 to which the permanent magnets 46a, 46b are bonded is attached. The yoke 44 cannot be subjected to an angle adjustment.

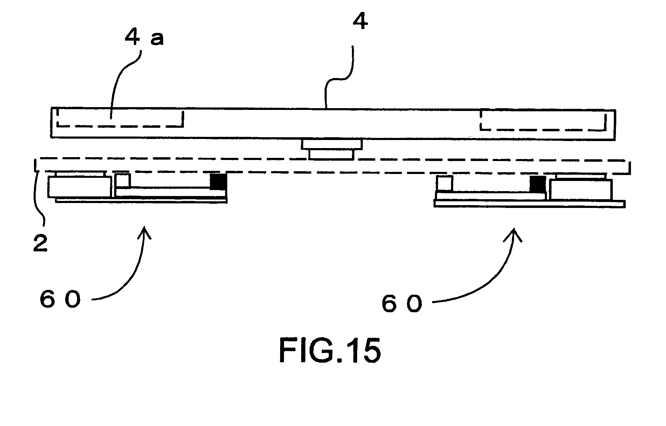

Figs. 15 to 17 each show Modified Embodiment 2 of a magnet apparatus. In Modified Embodiment 2, permanent magnets 66a, 66b are small in this magnet apparatus 60. By effectively taking advantage of the size in particular, the magnet apparatus 60 is made to be as thin as possible. In Fig. 15, the magnet apparatus 60 is disposed below the ring hearth 4.

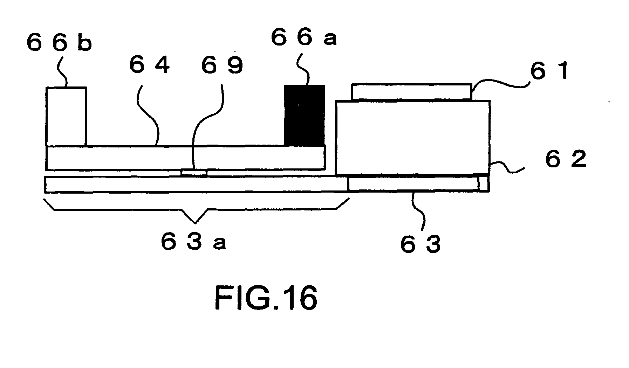

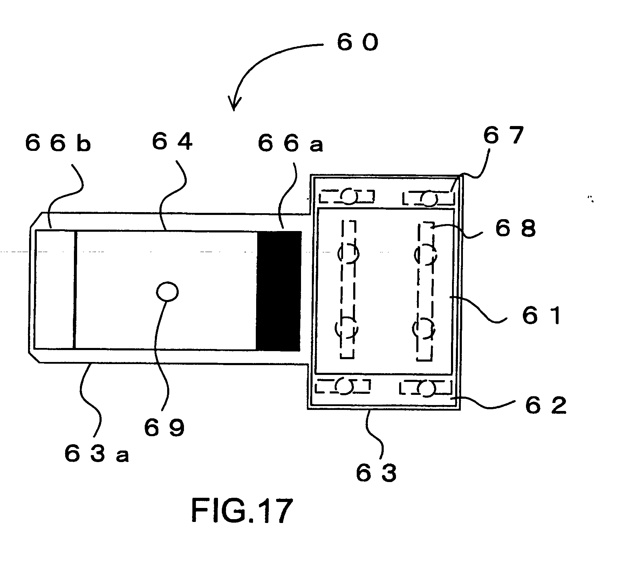

Fig. 16 is a front view of the magnet apparatus 60. Fig. 17 is a plan view of the magnet apparatus 60. A mounting plate 62 is mounted on a mounting bracket 61 so that a position of the mounting plate 62 can be adjusted rightwards and leftwards with a slot 67. A mounting plate 63 is mounted on the mounting plate 62 so that a position of the mounting plate 63 can be adjusted backwards and forwards with a slot 68. Further, a yoke 64 to which permanent magnets 66a, 66b are bonded is attached to an overhang 63a that laterally extends through a rotation center shaft 69. The yoke 64 can be subjected to an angle adjustment around the rotation center shaft 69.

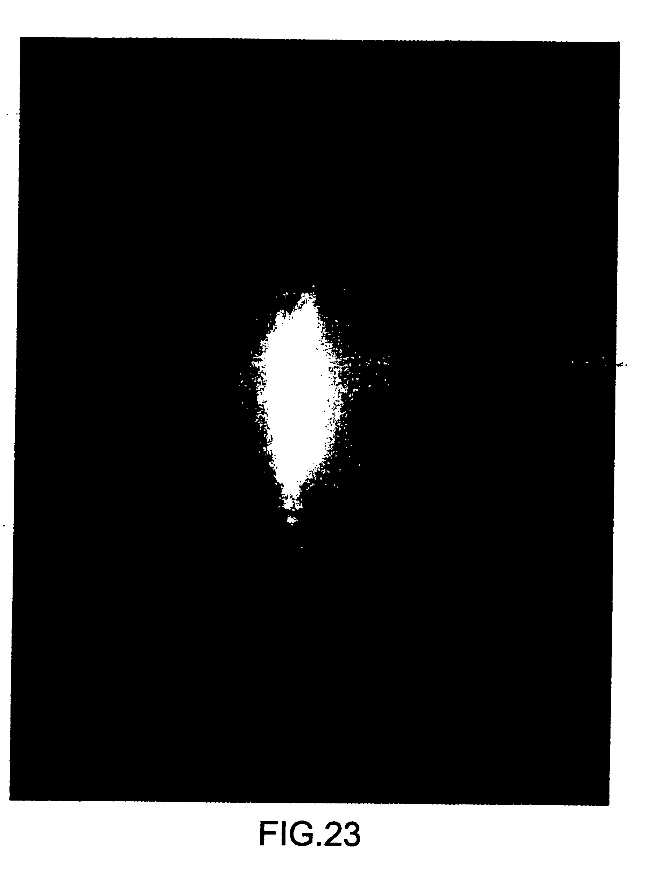

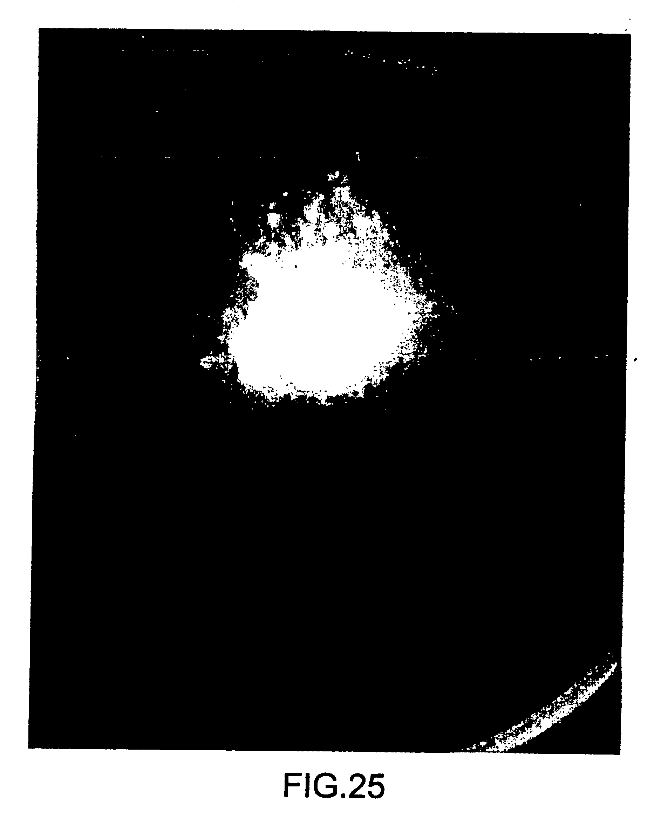

To compare the effects of the magnet apparatus 20 described above with those of the conventional apparatus, an experiment of an electron beam irradiation was carried out. A result of the experiment will be explained with reference to Figs. 23 to 25. Fig. 25 shows an observation result at the evaporation point P by the conventional electron-beam deflection apparatus 120. In the conventional technique, even when control is performed so that a quadrate beam shape is formed, the shape is distorted to be ellipse.

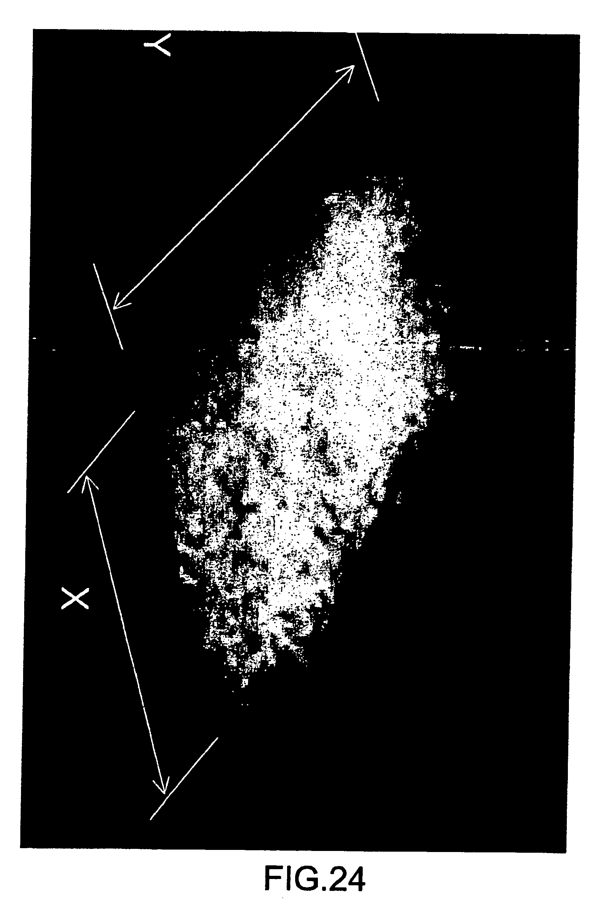

Fig. 23 shows an observation result at the evaporation point P by the magnet apparatus 20 according to this embodiment mode. The irradiation can be performed above the ring hearth 4 to form a quadrate beam shape. Fig. 24 shows an enlarged observation result at the evaporation point P by the magnet apparatus according to this embodiment mode. It is found that a desired quadrate beam shape was obtained, and an irradiation was performed without distortion based on the control of the deflecting coil (not shown) of the pierce-type electron gun 3.

The embodiment mode of the present invention is described above. The present invention is not of course limited to those, and can be variously modified based on the technical idea of the present invention.

The vacuum processing apparatus of the present invention is not for the vapor deposition of MgO only. The present invention can also be applied to a vacuum processing apparatus that employs a pierce-type electron gun.

In the in-line vacuum vapor deposition apparatus according to the embodiment mode of the present invention, the ring hearth 4 is used for a container for containing the vapor deposition material, but a rectangular hearth or a crucible may instead be used therefor.

The present invention can also be employed as a method for depositing a metal-oxide layer such as a SiO₂ layer, a TiO₂ layer, and an Al₂O₃ layer. The method for deposition according to the present invention may be employed as a method for depositing a metal layer such as an Al layer.

In the embodiment mode of the present invention, the permanent magnets used for deflecting the electron beam are provided on the atmosphere side of the vapor deposition chamber (outside the vapor deposition chamber).

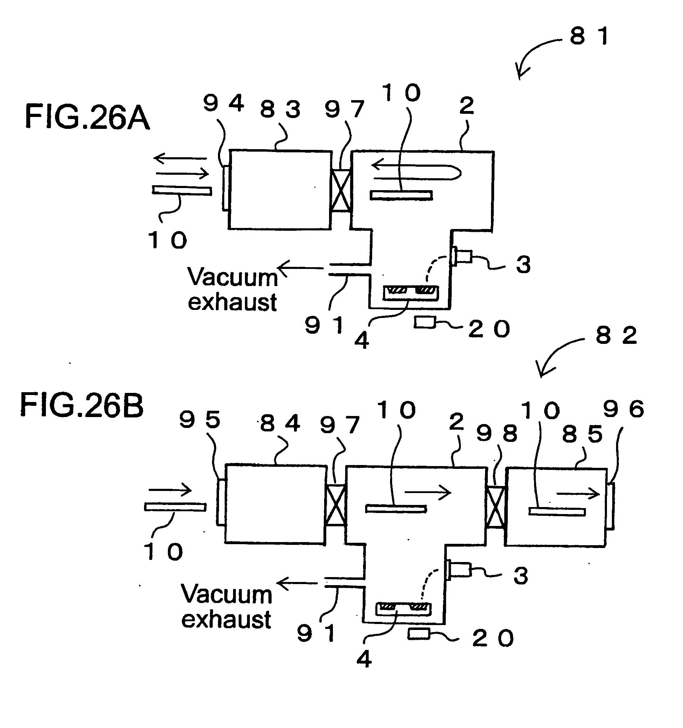

Further, the vacuum processing apparatus according to the present invention can be applied to various in-line vacuum vapor deposition apparatuses. Figs. 26 are schematic diagrams each showing an in-line vacuum vapor deposition apparatus. Fig. 26A shows an in-line vacuum vapor deposition apparatus 81 having two chambers, and Fig. 26B is an in-line vacuum vapor deposition apparatus 82 having three chambers. In the case of the two chambers, a structure in which the vapor deposition chamber 2 and a loading/unloading chamber 83 are separated by a gate valve is adopted. In the case of the three chambers, a structure in which the vapor deposition chamber 2, a loading chamber 84, and an unloading chamber 85 are separated by a gate valve is adopted.
In both cases, a structure in which while maintaining the vapor deposition chamber 2 in vacuum by closing the gate valve, doors 94 to 96 are opened/closed to load and unload the glass substrate 10 is adopted, which increases efficiency of the deposition.

## Claims

1. A vacuum processing apparatus (1) for irradiating a vapor deposition material (11) contained in an evaporation source (4) in a vacuum chamber (2) with an electron beam of a pierce-type electron gun (3) and forming a deposited layer on a processed substrate (10) opposed to the evaporation source (4), the vacuum processing apparatus (1) being **characterized in that** a magnet apparatus (20) for forming a magnetic field that is perpendicular to an incident direction of the electron beam and parallel to an electron-beam irradiation surface of the evaporation source (4) is provided outside the vacuum chamber (2) on a back side of the electron-beam irradiation surface, to deflect and guide the electron beam to an evaporation point of the evaporation source.

2. The vacuum processing apparatus according to claim 1, **characterized in that** the evaporation source (4) is a ring hearth.

3. The vacuum processing apparatus according to claim 1, **characterized in that** the magnet apparatus (20) is formed of a permanent magnet (26a, 26b).

4. The vacuum processing apparatus according to claim 1, **characterized by** being an in-line vacuum vapor deposition apparatus including at least two chambers of a loading/unloading chamber (83) and a vapor deposition chamber (2) or three chambers of a loading chamber (84), a vapor deposition chamber (2), and an unloading chamber (85), and wherein the pierce-type electron gun (3) is fixed to a sidewall surface of the vapor deposition chamber (2) with respect to a transfer direction of a processed substrate (10), and is adapted to be controlled such that the electron beam is emitted in a direction perpendicular to the transfer direction of the processed substrate (10).

5. The vacuum processing apparatus according to claim 4, **characterized in that** the apparatus is adapted such **that** two or more evaporation points are formed by jumping of the electron beam by a deflecting coil of the pierce-type electron gun (3).

6. The vacuum processing apparatus according to claim 5, **characterized in that** the apparatus is adapted such **that** the electron beam is jumped backwards and forwards or rightward and leftward by the deflecting coil of the pierce-type electron gun.

7. The vacuum processing apparatus according to claim 1, **characterized by** being an in-line vacuum vapor deposition apparatus including at least two chambers of a loading/unloading chamber (83) and a vapor deposition chamber (2) or three chambers of a loading chamber (84), a vapor deposition chamber (2), and an unloading chamber (85), and wherein the pierce-type electron gun (3) is fixed to a front or back wall surface of the vapor deposition chamber (2) with respect to a transfer direction of a processed substrate (10), and is adapted to be controlled such that the electron beam is emitted in a direction the same as the transfer direction of the processed substrate (10).

8. The vacuum processing apparatus according to claim 7, **characterized in that** the apparatus is adapted such **that** two or more evaporation points are formed by jumping of the electron beam by a deflecting coil of the pierce-type electron gun (3).

9. The vacuum processing apparatus according to claim 8, **characterized in that** the apparatus is adapted such **that** the electron beam is jumped backwards and forwards or rightwards and leftwards by the deflecting coil of the pierce-type electron gun (3).

## Patentansprüche

1. Vakuumbehandlungsvorrichtung (1) zur Bestrahlung eines Dampfabscheidungsmaterials (11), das in einer Verdampfungsquelle (4) in einer Vakuumkammer (2) enthalten ist, mit einem Elektronenstrahl einer Elektronenkanone vom Durchdringungstyp (3), und zur Bildung einer abgeschiedenen Schicht auf einem bearbeiteten Substrat (10) gegenüber der Verdampfungsquelle (4), wobei die Vakuumbehandlungsvorrichtung (1) **dadurch gekennzeichnet ist, dass** sich eine Magnetvorrichtung (20) zur Erzeugung eines magnetischen Feldes, das senkrecht zu einer einfallenden Richtung des Elektronenstrahls und parallel zu einer Elektronenstrahlbestrahlungsoberfläche der Verdampfungsquelle (4) ist, außerhalb der Vakuumkammer (2) auf einer Rückseite der Elektronenstrahlbestrahlungsoberfläche befindet, um den Elektronenstrahl abzulenken und ihn zu einem Verdampfungspunkt der Verdampfungsquelle zu führen.

2. Vakuumbehandlungsvorrichtung nach Anspruch 1, **dadurch gekennzeichnet, dass** die Verdampfungsquelle (4) ein Ringherd ist.

3. Vakuumbehandlungsvorrichtung nach Anspruch 1, **dadurch gekennzeichnet, dass** die Magnetvorrichtung (20) als ein Permanentmagnet (26a, 26b) ausgebildet ist.

4. Vakuumbehandlungsvorrichtung nach Anspruch 1, **dadurch gekennzeichnet, dass** sie eine Reihen-Vakuumdampfabscheidungsvorrichtung ist, die mindestens zwei Kammern, nämlich eine Beladungs-/Entladungskammer (83) und eine Dampfabscheidungskammer (2), oder drei Kammern, nämlich eine Beladungskammer (84), eine Dampfabscheidungskammer (2) und eine Entladungskammer (85), enthält, wobei die Elektronenkanone vom Durchdringungstyp (3) an einer Seitenwandoberfläche der Dampfabscheidungskammer (2) mit Bezug auf eine Übertragungsrichtung eines bearbeiteten Substrats (10) befestigt ist und wobei sie dafür ausgelegt ist, in der Weise gesteuert zu werden, dass der Elektronenstrahl in einer Richtung senkrecht zu der Übertragungsrichtung des bearbeiteten Substrats (10) abgestrahlt wird.

5. Vakuumbehandlungsvorrichtung nach Anspruch 4, **dadurch gekennzeichnet, dass** die Vorrichtung in der Weise ausgelegt ist, dass durch ein Springen des Elektronenstrahls durch eine ablenkende Spule der Elektronenkanone vom Durchdringungstyp (3) zwei oder mehrere Verdampfungspunkte gebildet werden.

6. Vakuumbehandlungsvorrichtung nach Anspruch 5, **dadurch gekennzeichnet, dass** die Vorrichtung in der Weise ausgelegt ist, dass der Elektronenstrahl durch die ablenkende Spule der Elektronenkanone vom Durchdringungstyp rückwärts und vorwärts oder nach rechts und links springt.

7. Vakuumbehandlungsvorrichtung nach Anspruch 1, **dadurch gekennzeichnet, dass** sie eine Reihen-Vakuumdampfabscheidungsvorrichtung ist, die mindestens zwei Kammern, nämlich eine Beladungs-/Entladungskammer (83) und eine Dampfabscheidungskammer (2), oder drei Kammern, nämlich eine Beladungskammer (84), eine Dampfabscheidungskammer (2) und eine Entladungskammer (85), enthält, wobei die Elektronenkanone vom Durchdringungstyp (3) in Bezug auf eine Übertragungsrichtung eines bearbeiteten Substrats (10) an einer vorderen oder hinteren Wandoberfläche der Dampfabscheidungskammer (2) befestigt ist und wobei sie dafür ausgelegt ist, in der Weise gesteuert zu werden, dass der Elektronenstrahl in dieselbe Richtung wie die Übertragungsrichtung des bearbeiteten Substrats (10) abgestrahlt wird.

8. Vakuumbehandlungsvorrichtung nach Anspruch 7, **dadurch gekennzeichnet, dass** die Vorrichtung in der Weise ausgelegt ist, dass durch ein Springen des Elektronenstrahls durch eine ablenkende Spule der Elektronenkanone vom Durchdringungstyp (3) zwei oder mehrere Verdampfungspunkte gebildet werden.

9. Vakuumbehandlungsvorrichtung nach Anspruch 8, **dadurch gekennzeichnet, dass** die Vorrichtung in der Weise ausgelegt ist, dass der Elektronenstrahl durch die ablenkende Spule der Elektronenkanone vom Durchdringungstyp (3) rückwärts und vorwärts oder nach rechts und links springt.

## Revendications

1. Appareil (1) de traitement sous vide destiné à irradier un matériau (11) de dépôt en phase vapeur contenu dans une source (4) d'évaporation dans une chambre (2) à vide à l'aide d'un faisceau d'électrons d'un canon (3) à électrons de type Pierce et à former une couche déposée sur un substrat traité (10) opposé à la source (4) d'évaporation, l'appareil (1) de traitement sous vide étant **caractérisé en ce qu'**un appareil (20) à aimant servant à former un champ magnétique perpendiculaire à une direction incidente du faisceau d'électrons et parallèle à une surface d'irradiation par faisceau d'électrons de la source (4) d'évaporation est placé à l'extérieur de la chambre (2) à vide sur une face arrière de la surface d'irradiation par faisceau d'électrons, pour dévier et guider le faisceau d'électrons jusqu'à un point d'évaporation de la source d'évaporation.

2. Appareil de traitement sous vide selon la revendication 1, **caractérisé en ce que** la source (4) d'évaporation est un foyer annulaire.

3. Appareil de traitement sous vide selon la revendication 1, **caractérisé en ce que** l'appareil (20) à aimant est formé d'un aimant permanent (26a, 26b).

4. Appareil de traitement sous vide selon la revendication 1, **caractérisé en ce qu'**il s'agit d'un appareil de dépôt en phase vapeur sous vide en production comprenant au moins deux chambres dont une chambre (83) de chargement /déchargement et une chambre (2) de dépôt en phase vapeur, ou trois chambres dont une chambre (84) de chargement, une chambre (2) de dépôt en phase vapeur et une chambre (85) de déchargement, et le canon (3) à électrons de type Pierce étant fixé à une surface de paroi latérale de la chambre (2) de dépôt en phase vapeur par rapport à une direction de transfert d'un substrat traité (10), et étant conçu pour être commandé de telle façon que le faisceau d'électrons soit émis dans une direction perpendiculaire à la direction de transfert du substrat traité (10).

5. Appareil de traitement sous vide selon la revendication 4, **caractérisé en ce que** l'appareil est conçu de telle façon qu'au moins deux points d'évaporation soient formés par un saut du faisceau d'électrons au moyen d'une bobine de déviation du canon (3) à électrons de type Pierce.

6. Appareil de traitement sous vide selon la revendication 5, **caractérisé en ce que** l'appareil est conçu de telle façon que le faisceau d'électrons subisse un saut dans la direction avant-arrière ou dans la direction droite-gauche au moyen de la bobine de déviation du canon à électrons de type Pierce.

7. Appareil de traitement sous vide selon la revendication 1, **caractérisé en ce qu'**il s'agit d'un appareil de dépôt en phase vapeur sous vide en production comprenant au moins deux chambres dont une chambre (83) de chargement / déchargement et une chambre (2) de dépôt en phase vapeur, ou trois chambres dont une chambre (84) de chargement, une chambre (2) de dépôt en phase vapeur, et une chambre (85) de déchargement, et le canon (3) à électrons de type Pierce étant fixé à une surface de paroi avant ou arrière de la chambre (2) de dépôt en phase vapeur par rapport à une direction de transfert d'un substrat traité (10), et étant conçu pour être commandé de telle façon que le faisceau d'électrons soit émis dans une direction qui est la même que la direction de transfert du substrat traité (10).

8. Appareil de traitement sous vide selon la revendication 7, **caractérisé en ce que** l'appareil est conçu de telle façon qu'au moins deux points d'évaporation soient formés par un saut du faisceau d'électrons au moyen d'une bobine de déviation du canon (3) à électrons de type Pierce.

9. Appareil de traitement sous vide selon la revendication 8, **caractérisé en ce que** l'appareil est conçu de telle façon que le faisceau d'électrons subisse un saut dans la direction avant-arrière ou droite-gauche au moyen de la bobine de déviation du canon (3) à électrons de type Pierce.
